# FASCICULE DE BREVET EUROPEEN

(11) **EP 2 673 816 B1**
(45) Date de publication et mention de la délivrance du brevet: **10.12.2014**
(21) Numéro de dépôt: 12705444.3
(22) Date de dépôt: 08.02.2012
(51) Int. Cl.: H01L 27/20, H01L 41/047, H01L 41/09

(54) **DISPOSITIF MICROELECTROMECANIQUE AVEC STRUCTURE D'ACTIONNEMENT PIEZOELECTRIQUE**
MIKROELEKTROMECHANISCHE VORRICHTUNG MIT PIEZOELEKTRISCHER BETÄTIGUNGSSTRUKTUR
MICROELECTROMECHANICAL DEVICE WITH PIEZOELECTRIC ACTUATION STRUCTURE

(30) Priorité: 09.02.2011 FR 1100403
(43) Date de publication de la demande: 18.12.2013
(73) Titulaire: Centre National de la Recherche Scientifique, 75016 Paris (FR)
(72) Inventeur: FAUCHER, Marc, F-59000 Lille (FR)
(74) Mandataire: Reboussin, Yohann Mickaël Noël
(86) Numéro de dépôt international: PCT/IB2012/050567
(87) Numéro de publication internationale: WO 2012/107888

(56) Documents cités:
- WO-A1-2010/064706
- US-A1- 2009 174 014
- US-B1- 7 426 067
- TONISCH K ET AL: "Piezoelectric actuation of all-nitride MEMS", PHYSICA STATUS SOLIDI (C) CURRENT TOPICS IN SOLID STATE PHYSICS - PAPERS PRESENTED AT THE 7TH INTERNATIONAL CONFERENCE OF NITRIDE SEMICONDUCTORS, ICNS-7 2008 WILEY-VCH VERLAG DEU, vol. 5, no. 6, 16 septembre 2007 (2007-09-16), pages 1910-1913, XP002656900, DOI: DOI:10.1002/PSSC.200778423 cité dans la demande
- BECK R G ET AL: "GaAs/AlGaAs self-sensing cantilevers for low temperature scanning probe microscopy", APPLIED PHYSICS LETTERS, AIP, AMERICAN INSTITUTE OF PHYSICS, MELVILLE, NY, US, vol. 73, no. 8, 24 août 1998 (1998-08-24), pages 1149-1151, XP012022032, ISSN: 0003-6951, DOI: 10.1063/1.122112

## Description

L'invention porte sur un dispositif microélectromécanique dont le fonctionnement est basé sur un effet piézoélectrique et constitué au moins en partie par un matériau semi-conducteur piézoélectrique, tel qu'un semi-conducteur de type III-N (nitrures d'éléments du groupe III).

Les dispositifs et systèmes microélectromécaniques (dits « MEMS » pour l'anglais « *Micro-Electro-Mechanical Systems* ») ont connu un développement important dans les dernières décennies. Fabriqués à l'aide de techniques empruntées à la microélectronique, ces dispositifs comportent typiquement des éléments mécaniques de dimensions submillimétriques (poutres encastrées, membranes...), ainsi que des actionneurs pour mettre en mouvement lesdits éléments mécaniques et/ou des capteurs pour détecter le mouvement desdits éléments mécaniques.

Lorsque les dimensions caractéristiques des éléments mécaniques sont inférieures au micromètre, on parle parfois de dispositifs et systèmes nanoélectromécaniques (dits « NEMS » pour l'anglais « *Nano-Electro-Mechanical Systems* »). Dans la suite, les expressions « MEMS » et « dispositif micromécaniques » seront utilisées dans un sens large, incluant les dispositifs et systèmes nanoélectromécaniques (NEMS).

Les documents WO2004/083110, US2007/0176211 et WO2010/116061 divulguent des MEMS de type à micro-poutre, réalisés en hétérostructure AlGaN/GaN, dans lesquels les mouvements de la micro-poutre sont détectés à l'aide d'un transistor de type HEMT intégré à l'hétérostructure.

L'article de K. Tonisch et al. « Piezoelectric actuation of all nitride MEMS », Phys. Stat. Sol. (c), No. 6, 1910 - 1913 (2008) porte plus spécifiquement sur le mécanisme d'actionnement des MEMS réalisés en hétérostructure AlGaN/GaN.

Les MEMS décrits par ces documents comportent une première couche en GaN déposée sur un substrat en Si, et une deuxième couche en AlGaN déposée sur ladite deuxième couche. Ces matériaux sont à la fois semi-conducteurs et piézoélectriques, et forment une hétérostructure confinant un gaz bidimensionnel d'électrons. L'actionnement est obtenu en appliquant une différence de potentiel aux bornes de la couche en AlGaN ; pour ce faire on utilise une électrode supérieure constituée par une couche de métallisation, tandis que le gaz bidimensionnel d'électrons joue le rôle d'électrode inférieure.

Dans ces conditions, l'interface entre la deuxième couche et l'électrode supérieure a un comportement rectifiant (jonction Schottky). Dans un régime de fonctionnement normal du dispositif, cette jonction doit être polarisée inversement, ou alors directement mais à un niveau de tension inférieur à V_{S}≅0,5V environ pour éviter le passage d'un courant électrique important, qui conduirait à une dégradation rapide de l'interface et en tout cas à une différence de potentiel mal définie aux bornes de la couche piézoélectrique. En d'autre termes, le potentiel V₂ de l'électrode supérieure doit être inférieur où égal à V₁+Vₛ, où V₁ est le potentiel du gaz bidimensionnel d'électrons faisant fonction d'électrode supérieure et V_{S}≅0,5V.

En même temps, si l'électrode supérieure est amenée à un potentiel inférieur à celui du gaz bidimensionnel d'électrons, ces derniers sont repoussés et la densité du gaz diminue. Lorsque la différence de potentiel V₂-V₁ devient inférieure à une valeur -V_{P} (typiquement de l'ordre de -4V), le gaz d'électrons disparait complètement et ne peut plus jouer le rôle d'électrode pour l'établissement d'un champ électrique dans la deuxième couche.

Par conséquent, un dispositif microélectromécanique connu de l'art antérieur ne peut fonctionner correctement que tant que sa tension d'actionnement V_{A}=V₂-V₁ évolue dans une plage relativement limitée, entre -V_{P} et V_{S}, c'est-à-dire typiquement entre -4V et 0,5V. Cela limite l'efficacité de l'actionnement.

Pour ces mêmes raisons, l'art antérieur ne permet pas de réaliser un dispositif microélectromécanique basé sur une hétérostructure du type « normalement éteint », c'est-à-dire ne présentant un gaz bidimensionnel d'électrons à l'interface entre les deux couches semi-conductrice que lorsque V₂-V₁≥kV_{E}>0. L'utilisation d'une hétérostructure de ce type serait avantageuse car elle permettrait la co-intégration de transistors à effet de champ de type « à enrichissement » (« *enhancement mode »* en anglais), appréciés pour leur faible niveau de consommation.

Des autres dispositifs de l'art antérieur sont connus par US 2009/0174014 A1, US 7 426 067 B1, WO 2010/064706 A1 et R.G. Beck et al., «GaAs/AlGaAs self-sensing cantilevers for low temperature scanning probe microscopy», Applied Physics Letters, vol. 73, p. 1149-1151, (1998).

L'invention vise à remédier aux inconvénients précités de l'art antérieur.

Un objet de l'invention, permettant d'atteindre ce but, est un dispositif microélectromécanique comportant :
- un substrat ;
- une première couche d'un premier matériau semi-conducteur, déposée sur une surface dudit substrat ;
- une deuxième couche d'un deuxième matériau semi-conducteur piézoélectrique différent dudit premier matériau semi-conducteur, déposée sur ladite première couche, lesdites première et deuxième couches formant une hétérostructure susceptible de confiner un gaz bidimensionnel de porteurs ;
- au moins un élément suspendu, formé par des prolongements desdites couches s'étendant au-delà d'un bord dudit substrat ; et
- une première et une deuxième électrodes d'actionnement pour établir une différence de potentiel entre ledit gaz bidimensionnel de porteurs et une face supérieure de ladite deuxième couche, opposée audit gaz bidimensionnel de porteurs, de manière à former une structure d'actionnement piézoélectrique dudit élément suspendu ;
caractérisé en ce qu'une couche diélectrique est prévue entre ladite deuxième électrode d'actionnement et ladite deuxième couche pour empêcher le passage d'un courant électrique entre elles.

Grâce aux propriétés isolantes de la couche diélectrique, le dispositif microélectromécanique de l'invention peut fonctionner correctement même avec une tension d'actionnement sensiblement positive, et supérieure à V_{S}, sans qu'un courant appréciable ne puisse passer de l'électrode supérieure à la couche semi-conductrice et piézoélectrique. La dynamique d'actionnement du dispositif s'en trouve considérablement améliorée.

Selon différents modes de réalisation particuliers de l'invention :
- Ladite couche diélectrique peut présenter une épaisseur inférieure à trois fois celle de ladite deuxième couche, de préférence entre 0,1 fois et 1 fois - et de manière encore plus préférée entre 0,1 fois et 0,3 fois - celle de ladite deuxième couche.
- Ladite couche diélectrique peut présenter une permittivité diélectrique relative supérieure ou égale à 3.
- Ladite couche diélectrique peut présenter un champ de claquage, ou rigidité diélectrique, supérieur ou égal à 0,5 fois celui de ladite deuxième couche, et de préférence supérieur ou égal à celui de ladite deuxième couche.
- La première et la deuxième couches peuvent être réalisées en des matériaux semi-conducteurs différents de type III-N. Plus particulièrement, ladite première couche peut être réalisée en GaN, ladite deuxième couche peut être réalisée en AlGaN, AlInN ou AlGalnN, et ladite couche diélectrique peut être réalisée en Al₂O₃. D'une manière conventionnelle :
   - AIGaN est une écriture abrégée pour AlₓGa_{y}N avec typiquement y=1-x et 0,1≤x≤0,35 et avantageusement 0,2≤x≤0,3 (idéalement, x=0,25) ;
   - AlInN est une écriture abrégée pour AlₓIn_{y}N avec typiquement y=1-x et 0,7≤x≤1 et avantageusement 0,8≤x≤0,9 (idéalement, x=0,83) ;
   - AlGalnN est une écriture abrégée pour AlₓGayln_{z}N avec typiquement z=1-x-y et 0,1≤(x+y)≤0,9 et avantageusement 0,75≤x≤0,85 ; 0,05≤y≤0,15 (idéalement, x=0,8 et y=0,1).
- Lesdites première et deuxième couches peuvent former une hétérostructure susceptible de confiner un gaz bidimensionnel de porteurs seulement lorsqu'une différence de potentiel est appliquée entre ces deux couches (hétérostructure « normalement éteinte »).
- Ledit élément suspendu peut présenter une forme choisie entre: une poutre, un disque ou une plaque. Plus précisément, il peut présenter une forme choisie entre : une poutre encastrée à ses deux extrémités et un disque ou plaque encastrés sur tout leur périmètre, lesdites première et deuxième électrodes d'actionnement étant agencées au niveau d'une partie d'encastrement dudit élément.
- Le dispositif peut comporter également un transistor à effet de champ intégré à ladite deuxième couche et/ou à son prolongement pour détecter des déplacements dudit élément suspendu, ledit transistor à effet de champ comprenant une électrode de source et une électrode de drain en contact électrique avec ledit gaz bidimensionnel d'électron, et une électrode de grille réalisée (généralement par dépôt) au-dessus de ladite deuxième couche, séparée par elle par une couche isolante. Avantageusement, ladite couche isolante peut être réalisée dans le même matériau, et déposée dans la même étape technologique, que ladite couche diélectrique.
- L'électrode de source dudit transistor à effet de champ, et/ou une piste conductrice en contact électrique avec ladite électrode, peut être connectée électriquement à ladite première électrode d'actionnement et interposée entre ladite deuxième électrode d'actionnement et l'électrode de drain du transistor, de manière à former un écran électrostatique. Cet agencement permet de minimiser les couplages, à la fois capacitifs et par conduction, entre la structure d'actionnement et le transistor de détection des oscillations de l'élément suspendu. Un tel agencement peut être appliqué à des dispositifs microélectromécaniques piézoélectriques indépendamment de l'utilisation de la couche diélectrique entre la deuxième électrode d'actionnement et la couche piézoélectrique.

D'autres caractéristiques, détails et avantages de l'invention ressortiront à la lecture de la description faite en référence aux dessins annexés donnés à titre d'exemples non limitatifs et qui représentent, respectivement :
- la figure 1, une vue en coupe de la structure d'actionnement d'un dispositif microélectromécanique selon un premier mode de réalisation de l'invention ;
- la figure 2, un graphique mettant en évidence l'élargissement de la plage admissible de variation de la tension d'actionnement obtenue grâce à l'invention ;
- la figure 3, une vue en coupe d'un dispositif microélectromécanique selon un deuxième mode de réalisation de l'invention ; et
- les figures 4 à 7, des vues en plan de dispositifs microélectromécaniques selon un troisième, quatrième, cinquième et sixième mode de réalisation de l'invention, respectivement.

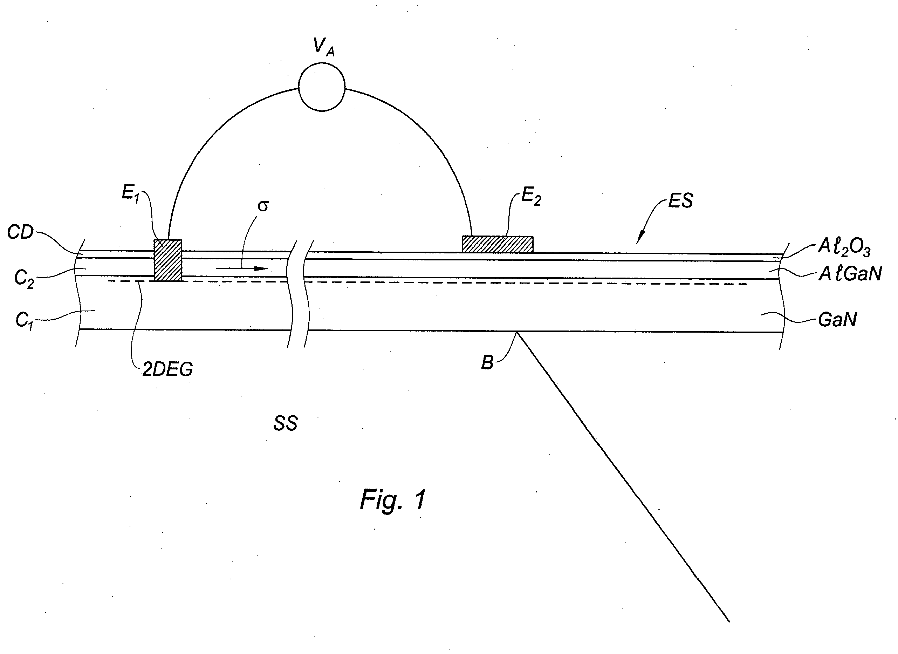

Le dispositif de la figure 1 est fabriqué à partir d'un substrat SS, qui peut être réalisé en Si, SiC, verre, ou tout autre matériau adapté, sur lequel sont déposées deux couches épitaxiales C₁ et C₂, respectivement en GaN et en AlGaN (plus précisément en AlₓGa₍₁₋ₓ₎N, par exemple en Al_{0,25}Ga_{0,75}N). L'AlGalnN ou l'AlInN peuvent aussi être utilisés.

Des prolongements des couches C₁ et C₂ s'étendent au-delà d'un bord B du substrat SS pour former un élément suspendu ES, en l'espèce un levier ou poutre encastré à une extrémité. Typiquement, le bord B n'est pas le bord latéral du substrat, mais le bord d'une cavité réalisé par gravure anisotrope après le dépôt des couches C₁ et C₂ afin de libérer l'élément suspendu ES.

La couche C₁ présente typiquement une épaisseur de quelques micromètres (1-5 µm, et par exemple 3 µm), tandis que la couche C₂ est sensiblement plus mince (10 - 100 nm, et par exemple 20 nm). Les dimensions de l'élément suspendu dépendent des caractéristiques mécaniques souhaitées : typiquement, mais d'une manière non limitative, un micro-levier peut avoir une longueur comprise entre 10 et 1000 µm et une largeur comprise entre 100 nm et 100 µm. On remarquera que la figure n'est pas à l'échelle.

Les matériaux constituant les couches C₁ et C₂ sont des semi-conducteurs présentant des bandes interdites de largeurs différentes : ils forment ainsi une hétérostructure. Plus précisément, il est connu qu'un gaz bidimensionnel d'électrons (indiqué par la référence 2DEG pour « 2-*dimensional electron gas* » en anglais) ou, dans certains cas, de trous, se forme dans la couche C₁, quelques nanomètres au-dessous de l'interface. Un tel gaz bidimensionnel de porteurs est très conducteur ; il peut être relié électriquement à la surface par l'intermédiaire d'un plot conducteur formant électrode, E₁, traversant la deuxième couche. Un tel plot peut être obtenu, d'une manière connue en soi, en déposant du métal sur la surface supérieure de la couche C₂, puis en chauffant l'ensemble de manière à faciliter la diffusion des atomes métalliques. Typiquement, on réalise un dépôt Ti/Al/Ni/Au d'une épaisseur totale de 400 nm qu'on recuit à 900°C pendant 1 min. On obtient ainsi, par diffusion et création d'alliages, un contact ohmique entre le métal et la couche C₂.

Une couche mince diélectrique CD est déposée au-dessus de la couche C₂, ou au moins d'une portion de sa surface supérieure. Cette couche peut recouvrir l'électrode E₁ (une ouverture étant prévue pour permettre la prise de contact avec cette électrode) ou pas ; dans ce dernier cas, l'ensemble du dispositif peut être avantageusement recouvert d'une deuxième couche diélectrique de passivation, non représentée (dans ce cas également, des ouvertures permettent les prises de contact).

Une métallisation est réalisée sur la couche CD à un emplacement situé à proximité de l'élément suspendu, formant une deuxième électrode E₂. Par application d'une différence de potentiel V_{A} entre la première électrode E₁ (et donc le gaz bidimensionnel d'électrons) et la deuxième électrode E₂, un champ électrique s'établit à travers la couche C₂, dans le sens de son épaisseur. Etant donné que le matériau constituant C₂ (AlGaN) est piézoélectrique en plus d'être semi-conducteur, une contrainte mécanique est générée à l'intérieur de la couche, ce qui provoque un actionnement mécanique (en l'espèce : une flexion) de l'élément suspendu ES ; sur la figure, la référence σ indique la direction de la contrainte principale, qui dans ce cas gît dans le plan de la couche et est parallèle à l'orientation du levier ES. La tension VA peut être oscillatoire, par exemple sinusoïdale avec éventuellement une composant continue, et présenter une fréquence résonante avec un mode d'oscillation mécanique de l'élément suspendu. Dans le cas d'un actionnement en flexion, pour que ce mécanisme d'actionnement puisse être efficace, il est préférable que la deuxième électrode soit déposée à proximité immédiate du bord B, voire sur l'élément suspendu lui-même, tandis que la première électrode E₁ doit, de préférence, être suffisamment éloignée pour ne pas perturber l'orientation des lignes de force du champ électrique et pour rendre négligeable le courant circulant entre les deux électrodes (une distance de l'ordre de quelques micromètres, voire un micromètre, peut suffire).

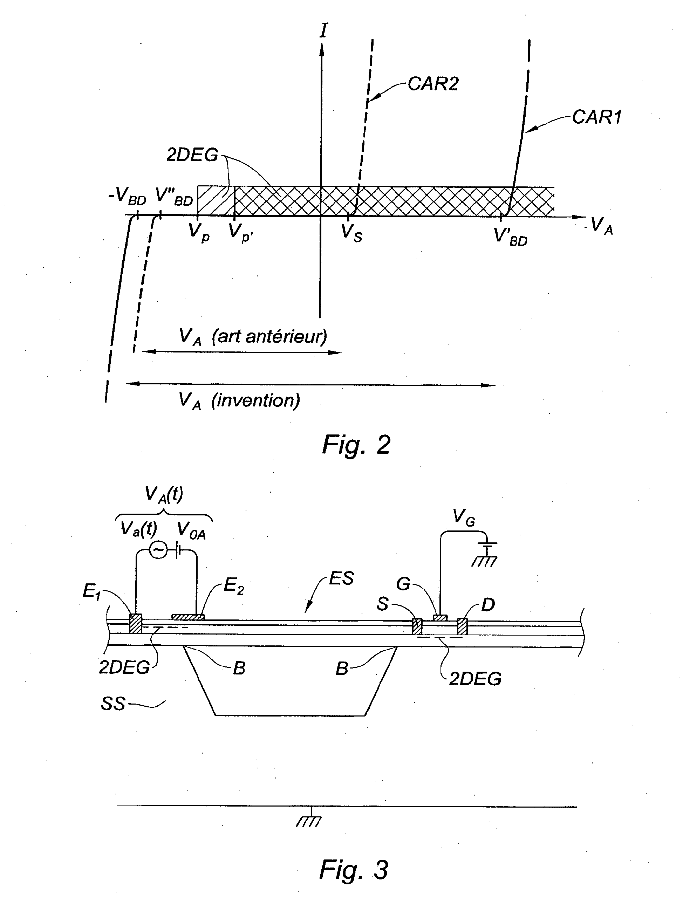

La tension VA peut être positive (auquel cas la première électrode E₁ se trouve à un potentiel inférieur à celui de la deuxième électrode E₂) ou négative (auquel cas la première électrode E₁ se trouve à un potentiel supérieur à celui de la deuxième électrode E₂). Cependant, comme le montre la courbe CAR1 sur le graphique tension-courant de la figure 2, elle ne peut pas varier sans limites. En effet, plus elle est négative, plus la densité du gaz bidimensionnel d'électrons 2DEG diminue, car les électrons sont repoussés par la deuxième électrode ; lorsque la valeur absolue de VA dépasse une valeur limite V_{P} (tension de pincement, typiquement de l'ordre de 5V), ce gaz disparait complètement (pincement). La présence/absence du gaz bidimensionnel d'électrons est représentée symboliquement sur la figure 2 par une bande hachurée. En conditions de pincement, il n'y a plus de parcours conducteur reliant l'électrode E₁ et la région immédiatement au-dessous de l'électrode supérieure E₂; par conséquent, les lignes de force du champ électrique changent de configuration pour relier directement ces deux électrodes : elles deviennent très inclinées, voire presque parallèles à la couche C₂, et l'intensité du champ diminue ; l'actionnement devient alors très inefficace. Si on continue à augmenter la valeur absolue de V_{A} au-delà d'une deuxième valeur limite V_{BD} un courant intense commence à circuler entre les deux électrodes à cause de la formation d'un arc électrique (ou « claquage »), ce qui peut conduire à la destruction du dispositif.

Pour des valeurs positifs de VA, l'actionnement continue à fonctionner correctement (il n'y a pas de pincement) jusqu'à la rupture par claquage lorsque V_{A}>V_{BD}'. On remarquera que V_{BD}'<V_{BD} car la configuration des lignes de champ est différente que dans le cas précédent.

En conclusion, la tension d'actionnement V_{A} peut varier utilement entre -V_{P} et V_{BD}', c'est-à-dire sur une plage d'environ 8V.

La courbe CAR2 illustre les conditions de fonctionnement d'un dispositif selon l'art antérieur, dans lequel la deuxième électrode E₂ est disposée en contact direct avec la couche C₂, sans interposition de la couche diélectrique CD.

Pour des tensions VA négatives, le fonctionnement est sensiblement le même que pour le dispositif de l'invention, à ceci près que le pincement se produit au-delà d'un seuil V_{P}'<V_{P}. Cela s'explique facilement. En effet, seule la différence de tension aux bornes de la couche C₂ contribue effectivement au pincement (et à l'actionnement) ; or, dans un dispositif selon l'art antérieur la tension VA est directement appliquée aux bornes de cette couche, tandis que dans le dispositif de l'invention elle se repartit entre la couche diélectrique CD et la couche C₂ selon le principe du partiteur capacitif. Pour la même raison, le claquage se produit à une tension V_{BD}", inférieure (en valeur absolue) à V_{BD}. On remarquera que l'élargissement de la plage d'actionnement du dispositif selon l'invention qui est obtenue de cette manière n'est qu'apparente : certes, la tension V_{A} peut prendre une valeur absolue plus importante, mais seule une fraction α<1 de cette tension contribue effectivement à l'actionnement ; et le pincement se produit toujours lorsque la tension d'actionnement effective α V_{A} atteint la valeur de seuil V_{P}.

C'est pour des tensions d'actionnement positives que l'avantage procuré par la couche diélectrique CD apparait clairement. En effet, comme expliqué plus haut, en l'absence d'une telle couche, un courant électrique s'établit dès que VA dépasse une valeur de seuil V_{S} égal à 0,5 V environ. Le courant croit rapidement avec la tension, ce qui fait que V_{A} ne peut pas augmenter sensiblement au-delà de V_{S}. En outre, le passage du courant est susceptible de provoquer une dégradation de l'interface entre l'électrode E₂ et la couche C₂.

La couche diélectrique CD doit de préférence être aussi mince que possible. En effet, comme expliqué plus haut, les couches CD et C₂ forment un partiteur capacitif, ce qui fait que seulement une fraction α<1 de la tension VA contribue effectivement à l'actionnement de la couche diélectrique C₂. Or, le facteur α est d'autant plus proche de l'unité que la couche CD est mince.

Une limite inférieure à l'épaisseur de la couche CD est imposée par la nécessité d'assurer qu'elle constitue une bonne barrière au passage d'un courant électrique. En outre, une couche CD trop mince pourrait être excessivement sensible au claquage.

Dans certaines applications, la couche diélectrique CD peut être aussi mince qu'une monocouche atomique (environ 0,3 nm) ou, au contraire, présenter une épaisseur supérieure, jusqu'à 300 nm environ, ou jusqu'à trois fois l'épaisseur de la couche piézoélectrique C₂. De préférence, cependant, l'épaisseur de la couche CD sera comprise entre 0,1 fois et 1 fois - et de manière encore plus préférée entre 0,1 fois et 0,3 fois - celle de ladite couche diélectrique C₂.

Afin de maximiser le facteur α, et donc l'efficacité de l'actionnement, il est également opportun que la couche diélectrique présente une permittivité diélectrique relative aussi grande que possible, en général supérieure ou égale à 3,9. L'alumine, Al₂O₃ se révèle un choix particulièrement avantageux en raison de sa permittivité diélectrique de l'ordre de 9. Il en va de même pour le nitrure de silicium, Si₃N₄, de permittivité 7,5 environ. L'oxyde de silicium SiO₂, avec une permittivité diélectrique de l'ordre de 3, constitue un choix moins avantageux.

Au moins pour des valeurs positives de VA, la dynamique d'actionnement est limitée par le claquage qui peut se produire soit dans la couche piézoélectrique C₂, soit dans la couche électrique CD. Il est donc opportun que ces deux couches présentent des champs de claquage comparables (le champ de claquage, ou rigidité diélectrique, étant défini comme le champ électrique maximal pouvant être appliqué sans induire un claquage). Typiquement, la couche CD peut présenter un champ de claquage supérieur ou égal à 0,5 fois celui de la couche C_{2,} et de préférence supérieur ou égal à celui de ladite couche. Là encore, Al₂O₃ se révèle un choix particulièrement avantageux, grâce à son champ de claquage supérieur à 4MV/cm.

La figure 3 montre un dispositif microélectromécanique selon un mode de réalisation de l'invention, comprenant un élément suspendu ES de type à poutre doublement encastrée.

A une première extrémité de la poutre se trouve un actionneur tel que décrit ci-dessus, présentant cependant la particularité d'être basé sur une hétérostructure du type « normalement éteint ». Cela signifie que les deux matériaux formant les couches C₁ et C₂ sont choisis de telle manière qu'à leur interface il n'y ait pas de gaz bidimensionnel de porteurs, sauf si une différence de potentiel positive est appliquée entre les électrodes E₂ et E₁. Dans ces conditions, le signal d'actionnement V_{A}(t) doit comporter une composante continue, ou de polarisation, V_{0A} permettant de créer un gaz bidimensionnel d'électrons 2DEG, et une composante oscillatoire Vₐ(t) excitant un mode de résonance de la poutre. Une hétérostructure « normalement éteinte » est décrite dans l'article de F. Medjdoub et al. « Novel E-Mode GaN-on-Si MOSHEMT Using a Selective Thermal Oxidation", IEEE Electron Device Letters, Vol. 31, No. 9, Sept. 2010, pp. 948 - 950.

A l'extrémité opposée de la poutre se trouve un transistor T de type HEMT, permettant la détection des oscillations de l'élément suspendu. Ce transistor, qui est également « normalement éteint » comprend une électrode de grille G, séparée de la couche C₂ par une couche isolante de grille CIG, permettant d'appliquer la tension V_{G}, positive par rapport au substrat SS, de nécessaire à générer un gaz bidimensionnel d'électrons, ainsi qu'une électrode de source S et une électrode de drain D, en contact avec ledit gaz bidimensionnel d'électrons. Avantageusement, la couche isolante de grille CIG et la couche diélectrique de la partie d'actionnement du dispositif peuvent être réalisées en un même matériau, et être déposées au cours d'une même étape technologique.

En variante, la partie d'actionnement et la partie de détection peuvent être réalisées d'un même coté de l'élément suspendu ES, certaines électrodes étant mutualisées entre l'actionneur et le transistor de détection (principe de la « grille résonante », décrit par les documents précités WO2004/083110, US2007/0176211 et WO2010/116061).

D'une manière connue en soi, l'élément suspendu pourra présenter des formes différentes : poutre simplement encastrée, membrane circulaire encastrée sur la totalité ou une partie de son bord, etc.

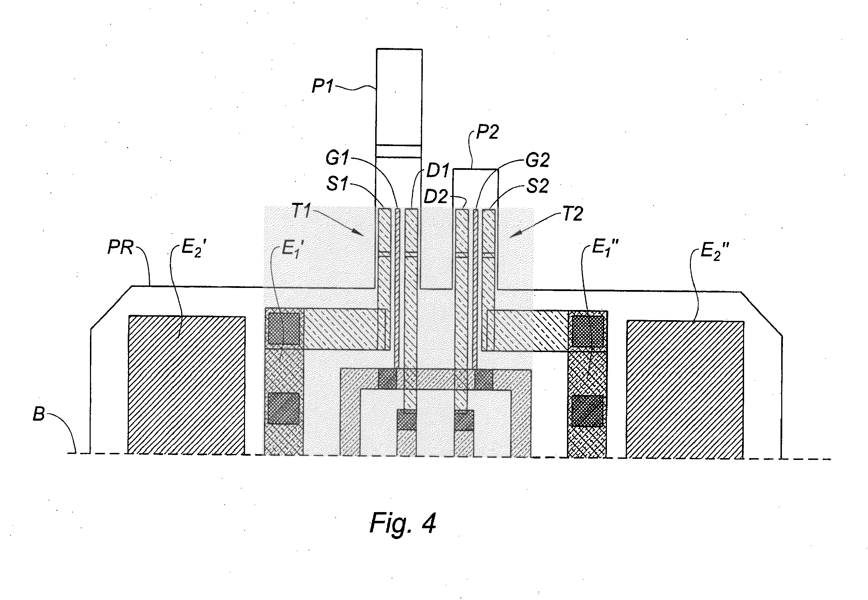

La figure 4 montre une vue en plan d'un dispositif microélectromécanique plus complexe, dans lequel l'élément suspendu comprend un « promontoire » PR dont se départent deux leviers ou poutres P1, P2 de longueurs différentes. On entend par « promontoire » un élément suspendu dont la largeur (parallèlement à la ligne d'encastrement avec le substrat, et donc au bord B dudit substrat) est sensiblement supérieure à la longueur (perpendiculairement à ladite ligne d'encastrement). Les électrodes d'actionnement sont disposées sur le promontoire, ce qui permet de remédier au problème constitué par le manque de place sur les poutres, dont la largeur peut être très faible (quelques micromètres).

Chaque poutre est équipée d'un transistor de détection respectif, T1, T2, comportant une électrode de drain D1, D2, une électrode de source S1, S2 et une électrode de grille, G1, G2 disposée entre le drain et la source. Dans le mode de réalisation de la figure 4 les électrodes de drain, de grille et de source des transistors de détection présentent une forme allongée et sont orientées dans le sens de la longueur des poutres.

Les poutres P1 et P2 étant du type simplement encastré, la structure d'actionnement et les transistors de détection sont agencés du même côté - celui d'encastrement - à proximité immédiate l'un de l'autre.

Les deux poutres P1 et P2 sont de longueurs différentes, de manière à avoir des fréquences de résonance distinctes ; ainsi, l'actionnement du promontoire met en résonance l'une seule de ces poutres, et pas l'autre. La poutre destinée à être excitée à sa fréquence de résonance (P1) peut - par exemple - présenter une surface fonctionnalisée de manière à servir en tant que capteur chimique. L'autre poutre (P2) est hors résonance avec la fréquence d'excitation, par conséquent elle n'oscille pratiquement pas. Son transistor T1 produit donc un signal « de référence », essentiellement dû au bruit et aux couplages parasites, qui doit être soustrait au signal issu du transistor T2 de la poutre active. Il s'agit donc d'une détection différentielle.

Mise à part la différente longueur des poutres P1, P2, le dispositif de la figure 4 présente une structure symétrique ; ainsi, les électrodes d'actionnement sont dédoublées : E₁', E₁" et E₂', E₂". Les deuxièmes électrodes d'actionnement E₂', E₂" se trouvent sur les côtés ; les premières électrodes E₁', E₁" se trouvent plus vers le centre du promontoire ; elles forment une structure (un contact ohmique) unique avec les sources S1, S2 des transistors de détection. Ces structures sont maintenues à un potentiel de référence, la « masse ». Elles sont interposées entre les premières électrodes d'actionnement et les drains des transistors, dont sont prélevés les signaux de sortie. Ainsi, elles captent les courants de fuite et assurent une fonction d'écrantage, minimisant les couplages parasites entre les parties d'actionnement et de détection du dispositif. Ces couplages parasites constituent un problème majeur dans les dispositifs microélectromécaniques de l'art antérieur, d'autant plus grave que la fréquence de fonctionnement est élevée.

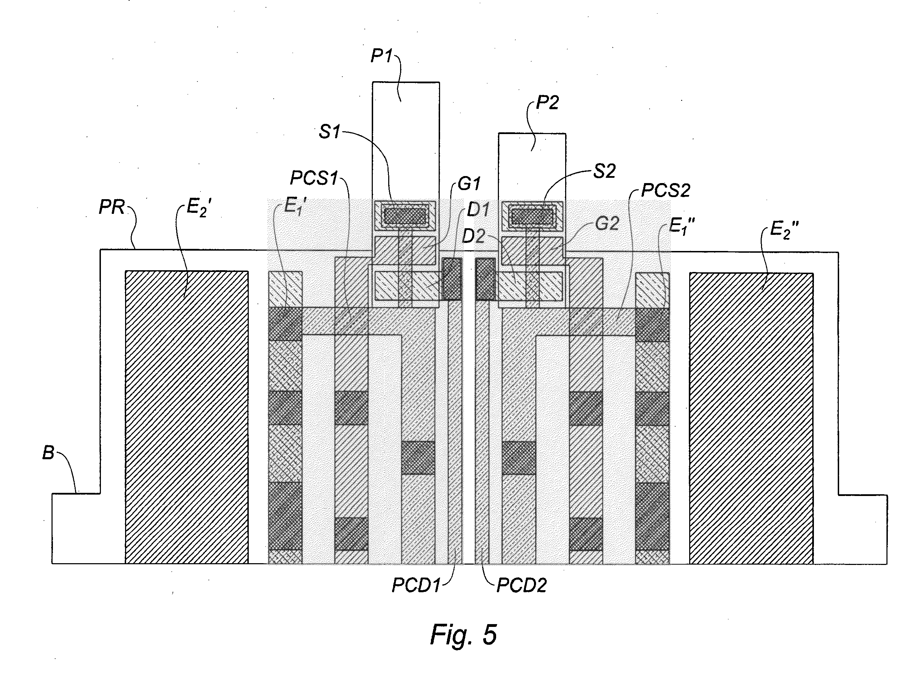

Sur la figure 4, mais aussi sur les figures 5 à 7, les métallisations de grille et de l'actionneur (deuxièmes électrodes) sont représentées par un hachurage gris clair ; les pistes de connexion, par un hachurage plus foncé ; les contacts ohmiques par un hachurage encore plus foncé. Les régions de petites dimensions caractérisées par un hachurage foncé correspondent aux zones d'ouverture dans le ou les couche(s) isolante(s).

Le dispositif de la figure 5 se différencie de celui de la figure 4 par l'orientation des transistors de détection. Leurs électrodes de drain, de grille et de source sont orientées dans le sens de la largeur des poutres et alignées dans le sens de leur longueur. Dans ce mode de réalisation, les premières électrodes d'actionnement et les électrodes de source des transistors sont formées par des contacts ohmiques séparés, mais connectés électriquement entre eux par des pistes conductrices PCS1, PCS2 déposées sur la surface du dispositif (mais sous la couche de passivation éventuelle). De même, les contacts ohmiques de drain sont connectés par l'intermédiaire de pistes conductrices respectives PCD1, PCD2.

Dans ce cas aussi, chaque ensemble constitué par une électrode de source, une première électrode d'actionnement et la piste conductrice reliant ces deux électrodes, forme un écran entre une deuxième électrode d'actionnement et le drain du transistor correspondant.

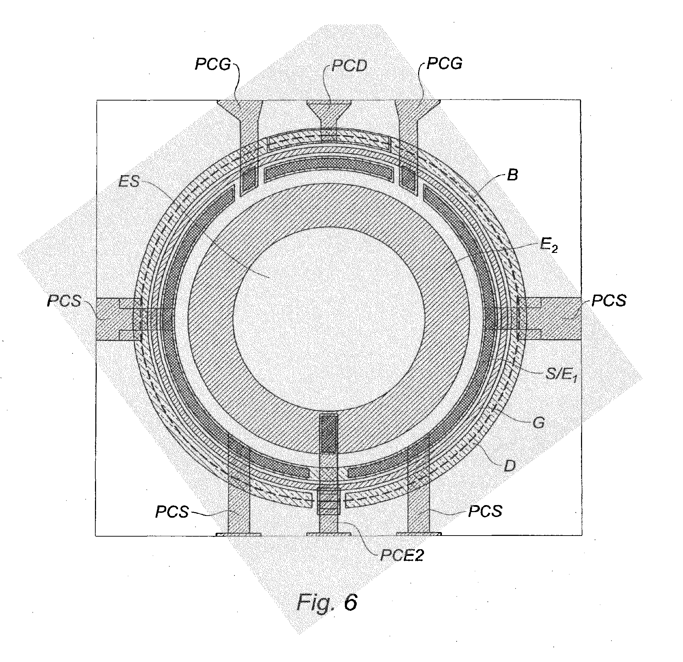

Dans le dispositif de la figure 6 l'élément suspendu ES se présente sous la forme d'une membrane circulaire encastrée sur tout son périmètre (le bord B du substrat est matérialisé par la ligne pointillée). La deuxième électrode d'actionnement E₂ se présente comme une piste conductrice circulaire déposée sur la membrane suspendue. L'électrode de source S - qui sert aussi de première électrode d'actionnement E₁ - est constituée par un contact ohmique, lui aussi de forme circulaire. Il en va de même pour l'électrode de drain D, qui dans ce mode de réalisation se trouve à cheval de la ligne d'encastrement de la membrane. L'électrode de grille présente une structure semblable à celle de la deuxième électrode d'actionnement. Du centre de la membrane vers la périphérie, l'ordre des électrodes est le suivant : deuxième électrode d'actionnement source/première électrode d'actionnement - grille - drain. On peut vérifier que, dans ce cas aussi, le contact ohmique circulaire formant à la fois l'électrode de grille du transistor et la première électrode d'actionnement agit comme écran entre la deuxième électrode d'actionnement et le drain.

Les références PCE2, PCG, PCD, PCS indiquent les pistes conductrices de connexion de l'électrode E₂, de la grille, du drain et de la source, respectivement.

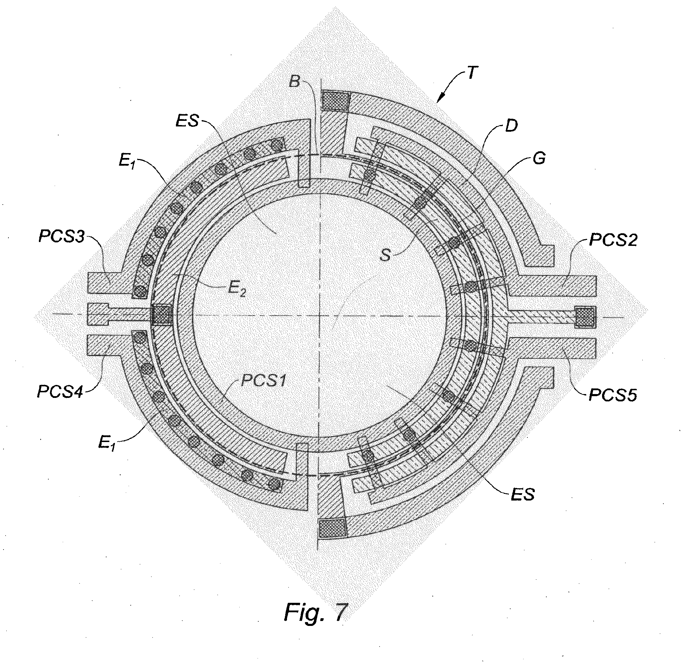

Dans le dispositif de la figure 7 l'élément suspendu ES se présente aussi sous la forme d'une membrane circulaire encastrée sur tout son périmètre. Cette fois-ci, cependant, les structures d'actionnement et de détection sont séparées : le transistor de détection T est sur la partie droite de la figure, tandis que la structure d'actionnement se trouve sur la partie gauche.

Les électrodes présentent une forme semi-circulaire. On remarque cinq pistes conductrices reliant entre elles - et à la masse - les électrodes de source et E₁: la piste circulaire PCS1, sur l'élément suspendu, et les quatre pistes extérieures PCS2 - PCS4. Il est facile de vérifier que ces pistes conductrices assurent l'écrantage entre la deuxième électrode d'actionnement et le drain du transistor de détection.

## Revendications

1. Dispositif microélectromécanique comportant :
- un substrat (SS) ;
- une première couche (C₁) d'un premier matériau semi-conducteur, déposée sur une surface dudit substrat ;
- une deuxième couche (C₂) d'un deuxième matériau semi-conducteur piézoélectrique différent dudit premier matériau semi-conducteur, déposée sur ladite première couche, lesdites première et deuxième couches formant une hétérostructure susceptible de confiner un gaz bidimensionnel de porteurs (2DEG) ;
- au moins un élément suspendu (ES), formé par des prolongements desdites couches s'étendant au-delà d'un bord (B) dudit substrat ; et
- une première (E₁) et une deuxième (E2) électrodes d'actionnement pour établir une différence de potentiel entre ledit gaz bidimensionnel de porteurs et une face supérieure de ladite deuxième couche, opposée audit gaz bidimensionnel de porteurs, de manière à former une structure d'actionnement piézoélectrique dudit élément suspendu ;
**caractérisé en ce qu'**une couche diélectrique (CD) est prévue entre ladite deuxième électrode d'actionnement et ladite deuxième couche pour empêcher le passage d'un courant électrique entre elles.

2. Dispositif microélectromécanique selon la revendication 1, dans lequel ladite couche diélectrique présente une épaisseur inférieure à trois fois celle de ladite deuxième couche, de préférence entre 0,1 fois et 1 fois - et de manière encore plus préférée entre 0,1 fois et 0,3 fois - celle de ladite deuxième couche.

3. Dispositif microélectromécanique selon l'une des revendications précédentes, dans lequel ladite couche diélectrique présente une permittivité diélectrique relative supérieure ou égale à 3.

4. Dispositif microélectromécanique selon l'une des revendications précédentes, dans lequel ladite couche diélectrique présente un champ de claquage supérieur ou égal à 0,5 fois celui de ladite deuxième couche, et de préférence supérieur ou égal à celui de ladite deuxième couche.

5. Dispositif microélectromécanique selon l'une des revendications précédentes, dans lequel la première et la deuxième couches sont réalisées en des matériaux semi-conducteurs différents de type III-N.

6. Dispositif microélectromécanique selon la revendication 5 dans lequel :
- ladite première couche est réalisée en GaN ;
- ladite deuxième couche est réalisée en AlGaN, AlInN ou AlGalnN ; et
- ladite couche diélectrique est réalisée en Al₂O₃.

7. Dispositif microélectromécanique selon l'une des revendications précédentes, dans lequel lesdites première et deuxième couches forment une hétérostructure susceptible de confiner un gaz bidimensionnel de porteurs seulement lorsqu'une différence de potentiel est appliquée entre ces deux couches.

8. Dispositif microélectromécanique selon l'une des revendications précédentes, dans lequel ledit élément suspendu présente une forme choisie entre: une poutre, un disque ou une plaque.

9. Dispositif microélectromécanique selon la revendication 8, dans lequel ledit élément présente une forme choisie entre :
- une poutre encastrée à ses deux extrémités ; et
- un disque ou plaque encastrés sur tout leur périmètre, lesdites première (E₁) et deuxième (E₂) électrodes d'actionnement étant agencées au niveau d'une partie d'encastrement dudit élément.

10. Dispositif microélectromécanique selon l'une des revendications précédentes comportant également un transistor à effet de champ (FET) intégré à ladite deuxième couche et/ou à son prolongement pour détecter des déplacements dudit élément suspendu, ledit transistor à effet de champ comprenant une électrode de source (S) et une électrode de drain (D) en contact électrique avec ledit gaz bidimensionnel d'électron, et une électrode de grille (G) réalisée au-dessus de ladite deuxième couche, séparée par elle par une couche isolante.

11. Dispositif microélectromécanique selon la revendication 10, dans lequel ladite couche isolante est réalisée dans le même matériau, et déposée dans la même étape technologique, que ladite couche diélectrique (CD).

12. Dispositif microélectromécanique selon la revendication 10 ou 11, dans lequel l'électrode de source dudit transistor à effet de champ, et/ou une piste conductrice (PCS1) en contact électrique avec ladite électrode, est connectée électriquement à ladite première électrode d'actionnement (E₁) et interposée entre ladite deuxième électrode d'actionnement (E₂) et l'électrode de drain du transistor, de manière à former un écran électrostatique.

## Patentansprüche

1. Mikroelektromechanische Vorrichtung, umfassend:
- ein Substrat (SS);
- eine erste Schicht (C₁) eines ersten Halbleitermaterials, welche auf einer Oberfläche des Substrats deponiert ist;
- eine zweite Schicht (C₂) eines von dem ersten Halbleitermaterial verschiedenen piezoelektrischen zweiten Halbleitermaterials, welches auf der ersten Schicht deponiert ist, wobei die erste und zweite Schicht eine Heterostruktur bilden, welche dazu geeignet ist, ein zweidimensionales Trägergas (2DEG) einzuschließen;
- wenigstens ein aufgehängtes Element (ES), welches durch Verlängerungen der Schichten gebildet ist, welche sich über einen Rand (B) des Substrats hinaus erstrecken; und
- eine erste (E₁) und eine zweite (E₂) Betätigungselektrode, um eine Potentialdifferenz zwischen dem zweidimensionalen Trägergas und einer oberen Seite der zweiten Schicht, gegenüber dem zweidimensionalen Trägergas, auf solche Weise herzustellen, dass eine piezoelektrische Betätigungsstruktur des aufgehängten Elements ausgebildet wird;
**dadurch gekennzeichnet, dass** eine dielektrische Schicht (CD) zwischen der zweiten Betätigungselektrode und der zweiten Schicht vorgesehen ist, um den Durchgang eines Strom dazwischen zu verhindern.

2. Mikroelektromechanische Vorrichtung nach Anspruch 1, wobei die dielektrische Schicht eine Dicke von weniger als dreimal derjenigen der zweiten Schicht, vorzugsweise zwischen 0,1 mal und 1 mal, und auf noch bevorzugtere Weise zwischen 0,1 mal und 0,3 mal, derjenigen der zweiten Schicht aufweist.

3. Mikroelektromechanische Vorrichtung nach einem der vorhergehenden Ansprüche, wobei die dielektrische Schicht eine relative dielektrische Permitivität von größer oder gleich 3 aufweist.

4. Mikroelektromechanische Vorrichtung nach einem der vorhergehenden Ansprüche, wobei die dielektrische Schicht ein Durchbruchfeld von größer oder gleich 0,5 mal demjenigen der zweiten Schicht und bevorzugt größer oder gleich demjenigen der zweiten Schicht aufweist.

5. Mikroelektromechanische Vorrichtung nach einem der vorhergehenden Ansprüche, wobei die erste und die zweite Schicht aus verschiedenen Halbleitermaterialien vom III-N-Typ realisiert sind.

6. Mikroelektromechanische Vorrichtung nach Anspruch 5, bei welcher:
- die erste Schicht aus GaN realisiert ist;
- die zweiten Schicht aus AlGaN, AlInN oder AlGalnN realisiert ist; und
- die dielektrische Schicht aus Al₂O₃ realisiert ist.

7. Mikroelektromechanische Vorrichtung nach einem der vorhergehenden Ansprüche, wobei die erste und zweite Schicht eine Heterostruktur bilden, welche dazu geeignet ist, ein zweidimensionales Trägergas einzuschließen, wenn eine Potentialdifferenz zwischen diesen zwei Schichten anliegt.

8. Mikroelektromechanische Vorrichtung nach einem der vorhergehenden Ansprüche, wobei das aufgehängte Element eine Form aufweist, welche ausgewählt ist aus: ein Balken, eine Scheibe oder eine Platte.

9. Mikroelektromechanische Vorrichtung nach Anspruch 8, wobei das Element eine Form aufweist, welche ausgewählt ist aus:
- ein Balken, welcher an seinen zwei Enden eingespannt ist; und
- eine Scheibe oder eine Platte, welche über ihren gesamten Umfang eingespannt sind,
wobei die erste (E₁) und zweite (E₂) Betätigungselektrode auf Höhe eines Einspannabschnitts des Elements angeordnet sind.

10. Mikroelektromechanische Vorrichtung nach einem der vorhergehenden Ansprüche, umfassend außerdem einen Feldeffekttransistor (FET), welcher in der zweiten Schicht und/oder ihrer Verlängerung integriert ist, um Verlagerungen des aufgehängten Elements zu erfassen, wobei der Feldeffekttransistor eine Source-Elektrode (S) und eine Drain-Elektrode (D) in elektrischem Kontakt mit dem zweidimensionalen Elektronengas, und eine Gate-Elektrode (G), welche über der zweiten Schicht von ihr durch eine Isolierschicht getrennt realisiert ist, aufweist.

11. Mikroelektromechanische Vorrichtung nach Anspruch 10, wobei die Isolierschicht aus demselben Material realisiert ist und in demselben Technologieschritt deponiert ist wie die dielektrische Schicht (CD).

12. Mikroelektromechanische Vorrichtung nach Anspruch 10 oder 11, wobei die Source-Elektrode des Feldeffekttransistors und/oder eine Leiterbahn (PCS1) in Kontakt mit der Elektrode elektrisch mit der ersten Betätigungselektrode (E₁) verbunden ist und zwischen der zweiten Betätigungselektrode (E₂) und der Drain-Elektrode des Transistors angeordnet ist, sodass ein elektrostatischer Schirm ausgebildet wird.

## Claims

1. Microelectromechanical device comprising:
- a substrate (SS);
- a first layer (C₁) of a first semiconductor material deposited on a surface of said substrate;
- a second layer (C₂) of a second piezoelectric semiconductor material different from said first semiconductor material deposited on said first layer, said first and second layers forming a heterostructure capable of confining a 2-dimensional charge-carrier gas (2DEG);
- at least one suspended element (ES) formed by extensions of said layers extending beyond an edge (B) of said substrate; and
- a first (E₁) and a second (E₂) actuating electrode for establishing a difference in potential between said 2-dimensional charge-carrier gas and a top face of said second layer opposite said 2-dimensional charge-carrier gas so as to form a piezoelectric structure for actuating said suspended element;
**characterised in that** a dielectric layer (CD) is provided between said second actuating electrode and said second layer to prevent an electric current from passing between them.

2. Microelectromechanical device as claimed in claim 1, in which said dielectric layer has a thickness less than three times that of said second layer, preferably between 0.1 time and 1 time - and even more preferably between 0.1 time and 0.3 time that of said second layer.

3. Microelectromechanical device as claimed in one of the preceding claims, in which said dielectric layer has a relative dielectric permittivity that is greater than or equal to 3.

4. Microelectromechanical device as claimed in one of the preceding claims, in which said dielectric layer has a breakdown field greater than or equal to 0.5 times that of said second layer and preferably greater than or equal to that of said second layer.

5. Microelectromechanical device as claimed in one of the preceding claims, in which the first and the second layers are made from different semiconductor materials of the III-N type.

6. Microelectromechanical device as claimed in claim 5, in which:
- said first layer is made from GaN;
- said second layer is made from AlGaN, AlInN or AlGalnN; and
- said dielectric layer is made from Al₂O₃.

7. Microelectromechanical device as claimed in one of the preceding claims, in which said first and second layers form a heterostructure capable of confining a 2-dimensional charge-carrier gas only when a difference in potential is applied between these two layers.

8. Microelectromechanical device as claimed in one of the preceding claims, in which said suspended element has a shape selected from a bar, a disc or a plate.

9. Microelectromechanical device as claimed in claim 8, in which said element has a shape selected from:
- a bar anchored at its two ends; and
- a disc or plate anchored around their entire perimeter,
said first (E₁) and second (E₂) actuator electrodes being disposed on a level with an anchored part of said element.

10. Microelectromechanical device as claimed in one of the preceding claims, further comprising a field-effect transistor (FET) integrated in said second layer and/or in its extension for detecting displacements of said suspended element, said field-effect transistor having a source electrode (S) and a drain electrode (D) in electrical contact with said 2-dimensional electron gas, and a gate electrode (G) disposed above said second layer, separated from it by an insulating layer.

11. Microelectromechanical device as claimed in claim 10, in which said insulating layer is made from the same material and deposited in the same technological step as said dielectric layer (CD).

12. Microelectromechanical device as claimed in claim 10 or 11, in which the source electrode of said field-effect transistor and/or a conductor track (PCS1) in electrical contact with said electrode is electrically connected to said first actuating electrode (E₁) and interposed between said second actuating electrode (E₂) and the drain electrode of the transistor so as to form an electrostatic screen.
